# FASCICULE DE BREVET EUROPEEN

(11) **EP 1 841 078 B1**
(45) Date de publication et mention de la délivrance du brevet: **03.06.2009**
(21) Numéro de dépôt: 07105260.9
(22) Date de dépôt: 29.03.2007
(51) Int. Cl.: H03M 13/29, H03M 13/41, H04N 5/775

(54) **Circuit de réception double canaux**
Zweikanal Empfangsschaltkreis
Dual channel receiver circuit

(30) Priorité: 29.03.2006 FR 0651084
(43) Date de publication de la demande: 03.10.2007
(73) Titulaire: ST MICROELECTRONICS S.A., 92120 Montrouge (FR)
(72) Inventeur: Meyer, Jacques, 38950 Saint Martin Le Vinoux (FR); Paille, Bruno, 38360 Engins (FR)
(74) Mandataire: de Beaumont, Michel

(56) Documents cités:
- US-A1- 2004 194 005
- US-A1- 2004 261 002
- HAGENAUER J, OFFER E, PAPKE L: "Improving the Standard Coding System for Deep Space Missions" IEEE INTERNATIONAL CONFERENCE ON COMMUNICATIONS. SUPERCOMM, vol. 2, 23 mai 1993 (1993-05-23), pages 1092-1097, XP002174972

## Description

### Domaine de l'invention

La présente invention concerne de façon générale les circuits de réception, par exemple les circuits de réception qui incluent deux décodeurs séparés par un dispositif de désentrelacement.
De tels circuits sont par exemple utilisés pour décoder des signaux vidéo numériques pouvant provenir par voie hertzienne d'un satellite (standard DVB-S, DVB-DSNG, DirecTV, etc) ou d'une base terrestre (standard DVB-T, DVB-H, ISDB, ISDB-T, ATSC, etc) ou pouvant être acheminés par un câble (standard DVB-C, Docsis, etc).

### Exposé de l'art antérieur

La publication américaine US2004/0194005 (Huggett) décrit le décodage d'un signal codé par blocs avec des décodeurs de Viterbi et de Reed-Solomon.

La publication américaine US2004/0261002 (Eidson) décrit le codage et le décodage d'un signal codé à l'aide d'un code externe et d'un code interne.

L'article de Hagenauer et al., "Improving the Standard Coding System of Deep Space Missions", IEEE international conference of communications (supercomm), 26-03-1998, pages 1092-1097 décrit le codage et le décodage d'un signal codé à l'aide d'un codeur de type RS suivi d'un codeur convolutionel.

Ces trois documents proposent un décodage itératif dans lequel la performance du décodeur de Viterbi est augmentée grâce à l'utilisation d'information selon laquelle les symboles décodés par le décodeur de Reed-Solomon lors de l'itération précédente sont réputés corrects.

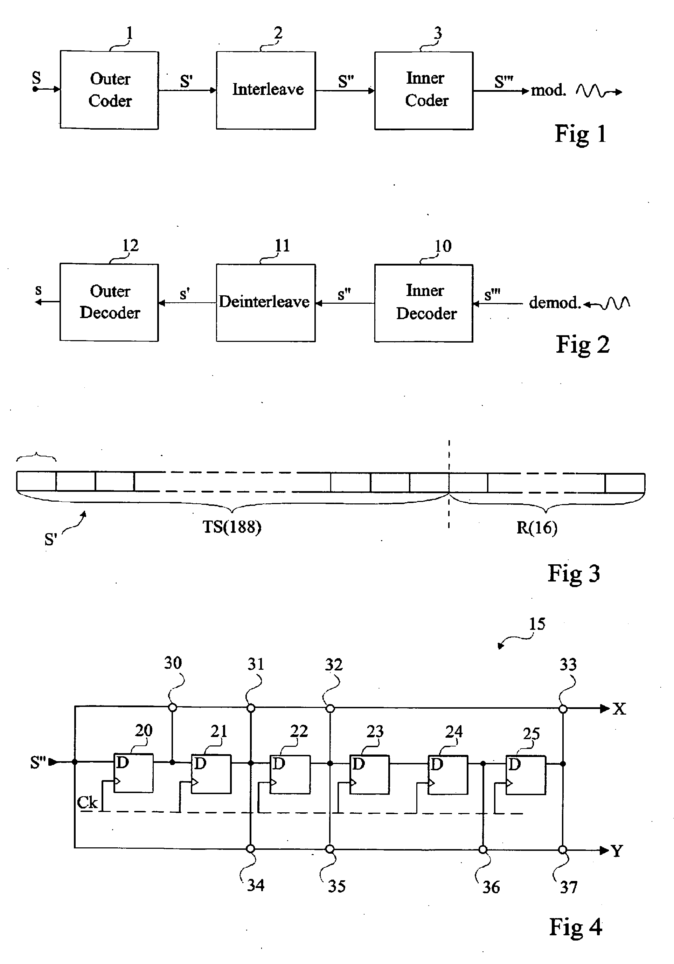

Les figures 1 et 2 sont des schémas illustrant respectivement les éléments d'un circuit d'émission fournissant un signal codé et ceux d'un circuit de réception utilisé pour décoder un tel signal codé.

Le circuit d'émission de la figure 1 comprend successivement un codeur 1, dit codeur externe- "outer coder" en anglais -, un dispositif d'entrelacement "Interleave" 2 et un codeur 3, dit codeur interne ou "inner coder" en anglais. Le codeur 1 opère par exemple à l'aide d'un code de type Reed Solomon, BCH, Hamming, etc. Le codeur 1 reçoit un signal numérique S à coder et fournit un signal S' au dispositif d'entrelacement 2. Le codeur 1 opère en général par paquets constitués de mots ou multiplets comprenant chacun un nombre donné de bits, 8 dans le cas d'octets. Le dispositif d'entrelacement 2 mélange entre eux les multiplets des différents paquets du signal S'. Le codeur 3 effectue un codage par exemple à l'aide d'un code de type convolutif, d'un Turbo code, d'un code LDPC, etc. Le codeur 3 reçoit un signal S" du dispositif 2 et fournit un signal S"', par exemple formé de symboles, qui sont modulés pour fournir un signal électromagnétique. Par exemple, une modulation à déplacement de phase à 4 états, plus connue sous le nom anglais de modulation "QPSK" (Quaternary Phase Shift Keying), est utilisée. Par exemple, pour fournir des signaux de type DVB-S, on utilise actuellement des circuits d'émission où le codeur 1 est un codeur de type Reed Solomon et le codeur 3 un codeur de type convolutif.

En figure 2, le circuit de réception reçoit un signal électromagnétique qui, après démodulation, se transforme en signal codé s"'. Le signal s"' est traité successivement par un décodeur 10 noté "inner decoder", un dispositif de désentrelacement 11 noté "Deinterleave" et un décodeur 12 noté "outer decoder". Le décodeur 10 effectue l'opération inverse du codeur 3 et fournit un signal s" au dispositif de désentrelacement 11. Le dispositif de désentrelacement 11 opère de façon inverse au dispositif d'entrelacement 2 et remet les multiplets de chaque paquet dans l'ordre où ils étaient avant entrelacement. Le décodeur 12 reçoit un signal s' du dispositif 11 et effectue l'opération inverse du codeur 1. Le décodeur 12 fournit un signal numérique décodé s. Lorsque le codeur 3 est un codeur de type convolutif, le décodeur 12 met en général en oeuvre un algorithme de Viterbi.

La figure 3 est un exemple de signal numérique S' fourni par le codeur 1. En figure 3, chaque paquet comprend 188 multiplets de données TS, correspondant à des multiplets du signal numérique S reçu par le codeur 1, et 16 multiplets de redondance R introduits par le codeur 1. La valeur des multiplets de redondance R est fonction de la valeur des multiplets TS.

La figure 4 représente un codeur convolutif 15 pouvant être utilisé comme codeur 3. Le codeur 15 comprend six bascules D 20 à 25 en série, la sortie de la bascule 20 étant connectée à l'entrée de la bascule 21 et ainsi de suite. La bascule 20 reçoit le signal S". Les bascules sont commandées par un signal d'horloge Ck de sorte qu'elles mémorisent la valeur "0" ou "1" présente sur leur entrée sur le front montant ou le front descendant du signal d'horloge. Le codeur 15 comprend en outre 8 portes de type OU exclusif 30 à 37. La porte 30 reçoit le signal S" et la sortie de la bascule 20. La porte 31 reçoit la sortie de la porte 30 et la sortie de la bascule 21. La porte 32 reçoit la sortie de la porte 31 et la sortie de la bascule 22. La porte 33 reçoit la sortie de la porte 32 et la sortie de la bascule 25. La porte 34 reçoit le signal S" et la sortie de la bascule 21. La porte 35 reçoit la sortie de la porte 34 et la sortie de la bascule 22. La porte 36 reçoit la sortie de la porte 35 et la sortie de la bascule 24. La porte 37 reçoit la sortie de la porte 36 et la sortie de la bascule 25. La porte 33 délivre un signal numérique X et la porte 37 délivre un signal numérique Y, les couples de valeurs X et Y formant le signal de sortie du codeur 15.

Les bits du signal S" sont introduits dans le codeur 15 les uns après les autres et se propagent de bascule en bascule au rythme du signal d'horloge Ck. Les signaux X et Y sont quant à eux constitués d'une suite de bits sortant du codeur 15 au rythme du signal d'horloge Ck.

On notera que chaque bit du signal X ou Y est une combinaison d'une partie des valeurs de 7 bits successifs du signal S", à savoir les 6 valeurs mémorisées par les bascules 20 à 25 et la valeur du bit positionné en entrée de la bascule 20.

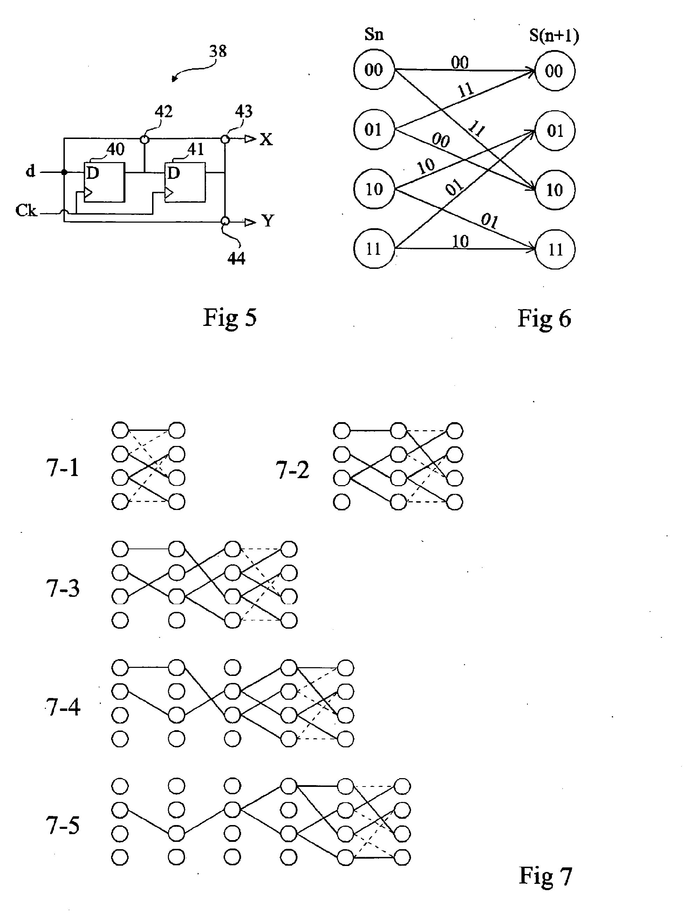

La figure 5 est un schéma d'un codeur convolutif 38 comprenant seulement deux bascules.

En figure 5, les bascules 40 et 41 sont connectées en série, la sortie de la bascule 40 étant connectée en entrée de la bascule 41. La bascule 40 reçoit un signal de données d. Les bascules sont commandées par un signal d'horloge Ck. Le codeur 38 comprend en outre trois portes OU exclusif 42, 43 et 44. La porte 42 reçoit le signal d et la sortie de la bascule 40. La porte 43 reçoit la sortie de la porte 42 et la sortie de la bascule 41. La porte 44 reçoit le signal d et la sortie de la bascule 41. Les portes 43 et 44 délivrent des signaux notés aussi X et Y.

La figure 6 illustre les changements d'états possibles des bascules 40 et 41. Chaque bascule peut mémoriser un "1" ou un "0". Les combinaisons possibles de valeurs mémorisées par la paire de bascules 40, 41, au nombre de 4, sont 00, 01, 10 et 11. Chaque combinaison possible est représentée par un cercle dans lequel sont inscrites les valeurs de la combinaison. Quatre cercles correspondant aux couples de valeurs possibles des bascules à un instant n, n étant un entier, sont représentés en colonne sur la gauche de la figure. De même, quatre cercles correspondant aux couples de valeurs possibles des bascules à un instant n+1 sont représentés en colonne sur la droite de la figure. L'état des bascules à l'instant n est appelé Sₙ. Après un coup d'horloge permettant de passer de l'état Sₙ à un état S₍ₙ₊₁₎, la bascule 41 mémorise la valeur précédemment mémorisée par la bascule 40 et la bascule 40 mémorise la valeur du signal de données d. Une nouvelle valeur du signal de données d apparaît par ailleurs en entrée de la bascule 40.

Si on appelle dₙ la valeur du signal d à l'instant n, les valeurs des signaux X et Y à l'instant n sont définies comme suit :

| dₙ | d₍ₙ₋₁₎ | d₍ₙ₋₂₎ | X | y |
|---|---|---|---|---|
| 0 | 0 | 0 | 0 | 0 |
| 1 | 0 | 0 | 1 | 1 |
| 0 | 0 | 1 | 1 | 1 |
| 1 | 0 | 1 | 0 | 0 |
| 0 | 1 | 0 | 1 | 0 |
| 1 | 1 | 0 | 0 | 1 |
| 0 | 1 | 1 | 0 | 1 |
| 1 | 1 | 1 | 1 | 0 |

Dans le cas par exemple où les bascules 40 et 41 sont dans l'état "00" à l'instant n, les signaux X et Y ont pour valeurs 00 ou 11 selon respectivement que la valeur du signal de données d est égale à 0 ou 1. A l'instant n+1, les bascules 40, 41 sont dans l'état 00 ou 01 selon respectivement que les signaux X, Y sont égaux à 00 ou 11 à l'état n. Deux flèches correspondant à ces deux possibilités sont représentées en figure 6 entre le cercle correspondant à l'état 00 à l'instant n représenté à gauche et les cercles correspondant aux états 00 et 10 à l'instant n+1 représentés à droite. Les chiffres indiqués au-dessus de chacune des flèches correspondent aux valeurs des signaux X, Y à l'instant n.

De même, chaque autre cercle correspondant à un état possible Sₙ est relié à deux autres cercles correspondant à deux états possibles S₍ₙ₊₁₎ par des flèches. Au-dessus de chaque flèche sont inscrites les valeurs des signaux X, Y à l'instant n permettant de passer de l'état Sₙ correspondant au cercle de départ de la flèche à l'état S₍ₙ₊₁₎ correspondant au cercle d'arrivée de la flèche.

L'ensemble des possibilités de changement d'états des bascules 40 et 41 lors de la réception d'un signal de données d comprenant un nombre N de bits successifs peuvent être représentées au moyen d'un "treillis" comprenant N+1 colonnes de quatre cercles. Chaque colonne correspond à un état Sₙ des bascules 40 et 41, la colonne correspondant à l'état S₍ₙ₊₁₎ étant placée à droite de la colonne correspondant à l'état Sₙ. La colonne la plus à gauche représente l'état initial S₀ des bascules avant d'insérer la première valeur du signal de données d dans la bascule 40. La colonne la plus à droite représente l'état S_{N} des bascules après insertion dans la bascule 40 de la dernière valeur du signal de données d. Chaque cercle d'une colonne est relié à deux autres cercles de la colonne suivante par des flèches sur lesquelles sont inscrites les valeurs des signaux X, Y permettant de passer d'un cercle à l'autre. En outre, chaque cercle d'une colonne est relié à deux autres cercles de la colonne précédente.

Un signal de données d peut être représenté à l'aide d'un tel treillis dans lequel on a supprimé entre chaque paire de colonnes correspondant à des états Sₙ et S₍ₙ₊₁₎ l'ensemble des flèches excepté une flèche correspondant à celle reliant les deux états Sₙ et S(ₙ₊₁) observés après entrée de la n-ième et de la (n+1)-ième valeur du signal d dans la bascule 40.

Afin de reconstituer un signal de données d fourni en entrée du codeur 38 de la figure 5, le décodeur doit retrouver quels étaient les états successifs des bascules 40 et 41 à partir des valeurs de signaux X', Y' reçus qui, aux erreurs de transmission près, correspondent aux signaux X, Y émis. Notamment, les valeurs X', Y' n'ont pas en général des valeurs bien définies 0 ou 1 (dites "hard" bits), mais présentent en général des valeurs réelles, de type analogique (dites "soft" bits). Le procédé de recherche des états successifs des bascules 40, 41 consiste, à partir d'un treillis complet, à éliminer progressivement des flèches de façon à obtenir un "chemin" unique entre les colonnes du treillis. Pour ce faire, on parcourt le treillis de gauche à droite au fur et à mesure de la réception des signaux X', Y' en éliminant des flèches du treillis de la façon décrite schématiquement ci-après, en relation avec la figure 7, qui illustre le procédé mis en oeuvre par un décodeur de Viterbi.

On définit d'abord des couples p1, p2, p3 et p4 de valeurs possibles pour les signaux X', Y', avec par exemple p1="00", p2="01", p3="10" et p4="11". Lors de la réception d'un nouveau jeu de valeurs des signaux X', Y', on affecte à chacun des couples p1 à p4 un nombre c appelé "coût" qui est d'autant plus élevé que le jeu de valeurs X', Y' reçu est différent du couple considéré. Dans un exemple simple où l'on assimile les valeurs reçues X' et Y' à des bits 0 ou 1, si le jeu de valeurs X' , Y' reçu est 00, on peut affecter au couple p1 égal à 00 un coût c(00) égal à 0, les couples p2 et p3 qui diffèrent d'un bit par rapport au couple reçu recevant des coûts c(01) et c(10) égaux à 1 et le couple p4, dont les deux bits sont différents des bits reçus, un coût c(11) égal à 2.

La figure 7 comporte une suite de schémas 7-1 à 7-5 représentant l'avancement de l'élimination des flèches du treillis au fur et à mesure de la réception des signaux X', Y'.

A chaque état représenté par un cercle, on affecte un coût cumulé. Au début du décodage, les coûts cumulés sont par exemple tous mis à zéro. Après réception du premier jeu de valeurs X', Y', on détermine un coût ou métrique pour chaque couple p1 à p4. On calcule alors pour chacune des deux flèches arrivant sur un cercle donné de la deuxième colonne un coût cumulé égal au coût cumulé du cercle d'origine de la flèche plus le coût associé au couple p1 à p4 correspondant à cette transition. On élimine la flèche correspondant au coût le plus élevé, puis on attribue au cercle de la deuxième colonne le coût cumulé de la flèche restante.

Après réception du deuxième jeu de valeurs X', Y', on détermine un nouveau coût pour chaque couple p1 à p4. On calcule alors comme précédemment pour chacune des deux flèches arrivant sur un cercle donné de la troisième colonne un coût cumulé égal au coût cumulé du cercle d'origine de la flèche dans la deuxième colonne plus le coût associé au couple p1 à p4 correspondant à cette transition. On élimine la flèche correspondant au coût le plus élevé, puis on attribue au cercle de la troisième colonne le coût cumulé de la flèche restante. On peut alors éliminer des flèches qui arrivent sur un cercle duquel ne repart aucune flèche vers la colonne suivante. Dans l'exemple de la figure 7 (schéma 7-3), on élimine ainsi la flèche partant du troisième cercle de la première colonne et arrivant sur le quatrième cercle de la deuxième colonne.

On continue ainsi pour chaque nouveau jeu de valeurs X' , Y' reçu. Il apparaît que le coût cumulé de chaque cercle de la dernière colonne est la somme des coûts de chaque flèche constituant le chemin unique menant à ce cercle. Comme cela est visible sur le schéma 7-5, au bout d'un certain nombre de jeux de valeurs X', Y' reçues, il ne reste plus qu'une seule flèche entre les première et deuxième colonnes et entre les deuxième et troisième colonnes. On peut alors noter les trois premiers états S₀, S₁ et S₂ des bascules et en déduire les deux premières valeurs du signal d que l'on cherche à reconstituer. Dans l'exemple de la figure 7, S₀=01 S₁=10 et S₂=01, les bascules étaient donc initialement positionnées à 01 puis les valeurs du signal d ont été successivement 1 puis 0.

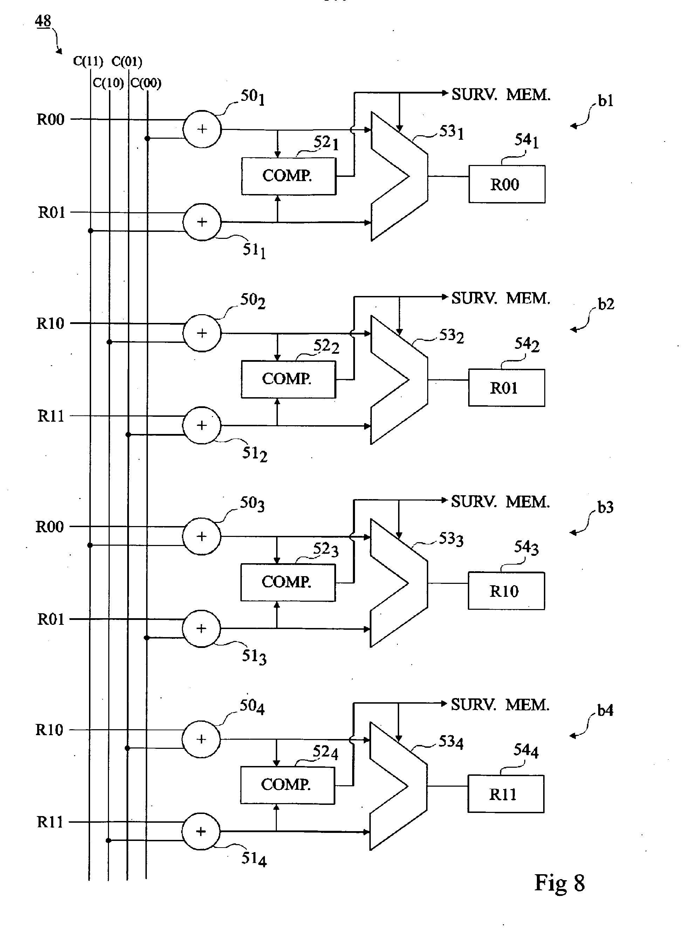

La figure 8 est un schéma d'une partie d'un décodeur 48 permettant de mettre en oeuvre le procédé de décodage décrit ci-dessus. Le décodeur 48 comprend quatre blocs b1, b2, b3 et b4 de structures identiques. Le j-ième bloc, j étant compris entre 1 et 4, comprend deux additionneurs 50ⱼ et 51ⱼ dont les sorties sont connectées à un comparateur 52ⱼ et à deux entrées d'un multiplexeur 53ⱼ. La sortie du multiplexeur 53ⱼ est connectée à un registre ou accumulateur 54ⱼ. Le multiplexeur 53ⱼ est commandé par le comparateur 52ⱼ.

Les registres 54₁ à 54₄ sont respectivement appelés R00, R01, R10 et R11. Chaque registre R00 à R11 est utilisé pour mémoriser la métrique cumulée associée à chaque cercle de la n-ième colonne après réception du n-ième jeu de valeurs X', Y'. Ainsi le registre R00 est associé au cercle correspondant à l'état Sₙ=00 et ainsi de suite.

Par ailleurs, les coûts c(00), c(01), c(10) et c(11) associés aux couples p1 à p4 sont fournis sur des lignes nommées aussi c(00), c(01), c(10) et c(11) .

Dans le cas du premier bloc b1, les entrées de l'additionneur 50₁ sont connectées au registre R00 et à la ligne c(00). Les entrées de l'additionneur 51₁ sont connectées au registre R01 et à la ligne c(11). On notera que ces connexions aux additionneurs 50₁ et 51₁ se déduisent du schéma de la figure 6. Ainsi, en se référant à la figure 6, il est possible de déduire les connexions aux additionneurs des autres blocs du décodeur.

Le fonctionnement du décodeur 48 est le suivant. Lorsqu'un n-ième jeu de valeurs X' , Y' est reçu, les lignes de coûts c(00) à c(11) sont mises à jour. Chaque j-ième bloc effectue alors les opérations suivantes. Les additionneurs 50ⱼ, 51ⱼ sont activés et fournissent chacun une valeur de somme. Le comparateur 52ⱼ détermine alors quelle est la somme la plus faible et commande le multiplexeur 53ⱼ afin que la somme la plus faible soit mémorisée dans le registre 54ⱼ. Cette opération de comparaison et de mémorisation correspond à l'élimination d'une des deux flèches arrivant sur le cercle associé au registre 54ⱼ et au calcul de la métrique cumulée associée à ce cercle.

Par ailleurs, le comparateur 52j de chaque bloc j est relié à une mémoire appelée "mémoire des survivants" qui permet de déterminer le chemin le plus probable suivi par les transitions entre états, par exemple en mémorisant les flèches restantes après chaque cycle d'addition/comparaison/mémorisation effectué après l'arrivée d'un nouveau jeu de valeurs X', Y'.

Le décodeur décrit ci-dessus en relation avec la figure 8 utilise un algorithme de Viterbi et permet le décodage de données codées par un codeur convolutif à deux bascules. Un décodeur de Viterbi correspondant à un codeur convolutif comprenant davantage de bascules, tel que celui de la figure 4, peut aisément être conçu selon le principe décrit ci-dessus.

Pour en revenir à la figure 2, le décodeur 12 analyse chaque paquet de multiplets provenant du dispositif de désentrelacement 11 et détermine à partir des multiplets de redondance s'il y a ou non des multiplets erronés dans le paquet. Si le nombre de multiplets erronés n'est pas trop important, ces derniers sont corrigés. Le décodeur élimine ensuite les multiplets de redondance et émet un signal corrigé s constitué uniquement des multiplets de données.

Les circuits de décodage et/ou de réception décrits ci-dessus permettent d'éliminer un certain nombre d'erreurs introduites dans les signaux lors de leur transmission entre le circuit d'émission et le circuit de réception.

Cependant, lorsque les supports de transmission sont fortement bruités, le nombre d'erreurs corrigées s'avère insuffisant. C'est par exemple le cas lorsque les transmissions sont effectuées par voie hertzienne, notamment à partir d'un satellite.

### Résumé de l'invention

Un objet de la présente invention est de prévoir un circuit qui permette de corriger davantage d'erreurs que les circuits de l'art antérieur.

Un autre objet de la présente invention est de prévoir un tel circuit de structure simple.

Pour atteindre ces objets, ainsi que d'autres, la présente invention prévoit un circuit de décodage d'un signal codé comprenant :
un premier système de décodage propre à recevoir le signal codé et à fournir un premier signal comportant des parties réputées correctes ; et
un deuxième système de décodage propre à fournir un second signal à partir du signal codé et de parties réputées correctes du premier signal.

Selon un mode de réalisation de la présente invention, le premier système de décodage comprend un premier décodeur, un premier dispositif de désentrelacement couplé au premier décodeur et un deuxième décodeur couplé au premier dispositif de désentrelacement ; le deuxième système de décodage comprend un troisième décodeur, un deuxième dispositif de désentrelacement couplé au troisième décodeur et un quatrième décodeur couplé au deuxième dispositif de désentrelacement.

Selon un mode de réalisation de la présente invention, le troisième décodeur est couplé à un dispositif de temporisation recevant le signal codé et au deuxième décodeur par l'intermédiaire d'un dispositif d'entrelacement.

Selon un mode de réalisation de la présente invention, le signal fourni par le dispositif d'entrelacement est formé de multiplets comportant des bits de validité indiquant si les multiplets sont corrects.

Selon un mode de réalisation de la présente invention, le premier décodeur est un décodeur utilisant un algorithme de Viterbi, et les deuxième et quatrième décodeurs sont des décodeurs correcteurs d'erreurs de type Reed Solomon.

Selon un mode de réalisation de la présente invention, le troisième décodeur comporte un ensemble de registres mémorisant une métrique mise à jour périodiquement, et des moyens de contrôle propres à forcer le contenu des registres à une valeur déterminée en fonction des valeurs du signal fourni par le premier système de décodage.

Selon un mode de réalisation de la présente invention, les moyens de contrôle détectent les multiplets corrects du premier signal et commandent le positionnement des registres pour chaque suite de n bits consécutifs appartenant à des multiplets corrects.

Selon un mode de réalisation de la présente invention, le troisième décodeur comprend un codeur couplé au dispositif d'entrelacement et un multiplexeur qui reçoit respectivement sur des première et seconde entrées le signal fourni par le dispositif de temporisation et le signal fourni par le codeur et fournit un signal à un cinquième décodeur, le multiplexeur étant commandé par un dispositif de commande agissant en fonction de la validité du signal alimentant le codeur.

La présente invention prévoit aussi un circuit de réception comprenant des premier et second canaux de réception permettant de recevoir deux signaux codés distincts, le premier canal de réception comprenant un premier démodulateur couplé à un premier circuit de décodage et le second canal de réception comprenant un second démodulateur couplé à un second circuit de décodage, le circuit comprenant en outre un multiplexeur à deux entrées et une sortie, un dispositif de temporisation et un dispositif de contrôle, le dispositif de temporisation étant couplé au premier démodulateur et les entrées du multiplexeur étant couplées respectivement au second démodulateur et au dispositif de temporisation, le dispositif de contrôle comprenant des moyens de génération d'un signal corrigé à partir de signaux fournis par le premier circuit de décodage et des moyens de commande du second circuit de décodage, un signal de sélection commandant le multiplexeur et le dispositif de contrôle, tel que, lorsque le signal de sélection est positionné pour laisser passer le signal fourni par le dispositif de temporisation, l'association des circuits de décodage des premier et second canaux, du dispositif de temporisation et du dispositif de contrôle constitue un circuit de décodage tel que défini ci-dessus.

La présente invention prévoit aussi un circuit de réception comprenant un premier démodulateur, un second démodulateur, les premier et second démodulateurs étant couplés à un dispositif de recombinaison, et un circuit de décodage tel que défini ci-dessus couplé au dispositif de recombinaison.

La présente invention prévoit aussi un procédé de décodage d'un signal codé comprenant les étapes suivantes :
effectuer un décodage du signal codé, en mettant en oeuvre un algorithme de Viterbi, pour fournir un premier signal constitué d'une suite de paquets de multiplets ;
identifier d'éventuelles erreurs présentes dans le premier signal, au moyen de multiplets de redondance inclus dans chaque paquet ;
corriger tout ou partie des multiplets erronés du premier signal pour former un signal prédécodé corrigé comprenant des indications sur la validité des multiplets ;
fournir un signal codé retardé ;
effectuer un décodage du signal codé retardé, en mettant en oeuvre un algorithme de Viterbi modifié par l'utilisation des informations obtenues à partir des multiplets corrects du signal prédécodé corrigé, pour fournir un second signal prédécodé ; et
identifier et corriger tout ou partie d'éventuelles erreurs présentes dans le second signal prédécodé; et
supprimer les multiplets de redondance du second signal prédécodé pour fournir un signal décodé.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma d'un circuit d'émission de signaux codés ;
la figure 2 est un schéma d'un circuit de réception de signaux codés ;
la figure 3 représente schématiquement une partie d'un signal numérique fourni par un codeur de type "Reed Solomon";
la figure 4 est un schéma d'un exemple de codeur convolutif ;
la figure 5 est un schéma d'un exemple simple de codeur convolutif ;
la figure 6 est un schéma illustrant les changements d'états possibles des bascules du codeur de la figure 5 ;
la figure 7 est un schéma d'un treillis représentant le procédé mis en oeuvre par un décodeur de Viterbi ;
la figure 8 est un schéma d'une partie d'un décodeur de Viterbi correspondant au codeur de la figure 5 ;
la figure 9 est un schéma d'un exemple de circuit selon la présente invention ;
la figure 10 est un schéma illustrant un procédé mis en oeuvre par des éléments du circuit de la figure 9 ;
la figure 11 est un schéma d'un mode de réalisation du circuit de la figure 9 ;
la figure 12 est un schéma illustrant le fonctionnement d'un dispositif du circuit de la figure 11 ;
la figure 13 est un schéma d'un autre mode de réalisation du circuit de la figure 9 ;
la figure 14 est un schéma illustrant un signal fourni par un dispositif du circuit de la figure 13 ;
la figure 15 est un schéma d'une partie d'un dispositif de décodage selon la présente invention ;
la figure 16 est un schéma classique d'un circuit de réception "double-canaux" permettant de traiter deux signaux codés ;
la figure 17 est un schéma selon un mode de réalisation de la présente invention d'un circuit de réception double-canaux pouvant fonctionner en circuit de réception "simple canal" ;
la figure 18 est un schéma selon un deuxième mode de réalisation de la présente invention ; et
la figure 19 est un schéma selon un autre mode de réalisation de la présente invention d'un circuit de réception double-canaux pouvant fonctionner en circuit de réception "simple canal".

### Description détaillée

Par souci de clarté, de mêmes éléments ou des éléments ayant au moins en partie de mêmes fonctions peuvent être désignés ci-après par de mêmes références aux différentes figures.

Selon la présente invention, un premier système de décodage reçoit un signal codé et fournit un premier signal, dans lequel une partie au moins a été corrigée et est réputée sans erreur. Un deuxième système de décodage décode à son tour le signal codé en se servant de toutes ou d'une partie seulement des parties réputées sans erreur du signal fourni par le premier système de décodage. Ainsi, le signal fourni par le deuxième système de décodage présente de façon générale moins d'erreurs que le signal fourni par le premier système de décodage.

La structure d'un circuit selon la présente invention et le procédé de décodage selon la présente invention seront mieux compris à la lecture des exemples de réalisation décrits ci-après.

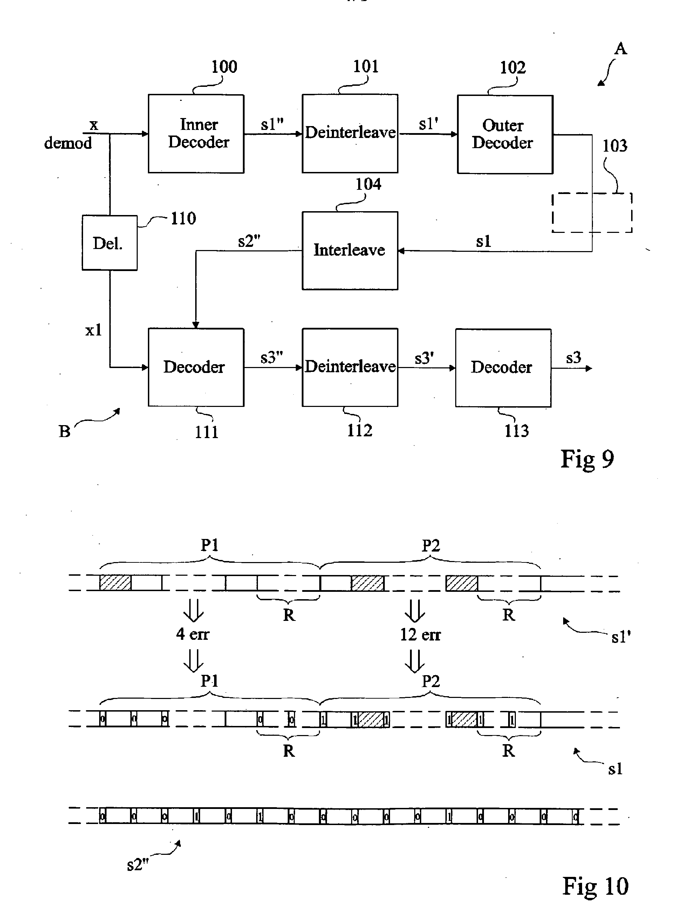

La figure 9 est un schéma d'un exemple de circuit de décodage selon la présente invention. Pour le besoin de la figure 9, on suppose que le signal a été codé par un circuit du type de celui de la figure 1, dans lequel le signal d'entrée a été codé par un codeur externe 1 et un codeur interne 3, séparés par un dispositif d'entrelacement 2. Le codeur externe a rajouté de la redondance qui permettra, au décodage, de corriger des erreurs et d'indiquer les parties sans erreur du signal. Le codeur interne a aussi ajouté de la redondance dans le sens où il fournit plus de bits qu'il n'en reçoit.

En figure 9, le circuit comprend deux systèmes ou chaînes de décodage A et B recevant chacun un signal codé x provenant de la démodulation d'un signal reçu. La chaîne A comprend successivement un décodeur 100, noté "inner decoder", un dispositif de désentrelacement 101 noté "Deinterleave" et un décodeur 102, noté "outer decoder". Le décodeur 100 décode le signal x et fournit un signal s1". Le dispositif de désentrelacement remet les multiplets du signal s1" dans l'ordre initial et fournit un signal s1'. Le décodeur 102 corrige des erreurs du signal s1' et fournit un signal s1 comportant des parties exactes ou supposées exactes dont la localisation est connue.

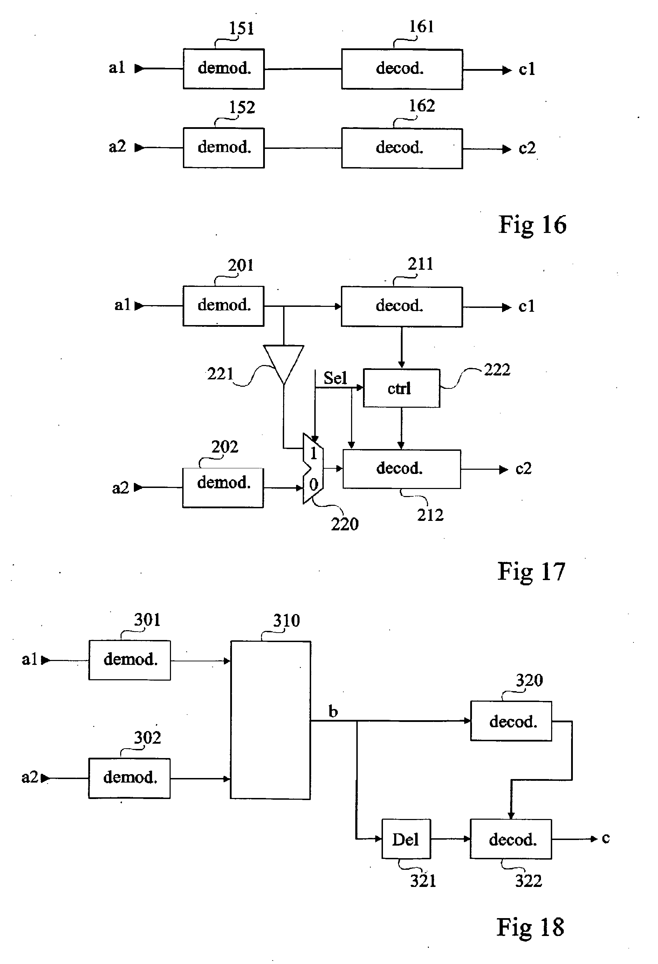

Par exemple, le décodeur 102 analyse chaque paquet de multiplets du signal s1' et détermine à partir de multiplets de redondance s'il y a ou non des multiplets erronés dans le paquet considéré. Le décodeur 102 compare le nombre de multiplets erronés dans le paquet considéré à un nombre maximal de mots erronés corrigibles "nmax" prédéfini, égal à 8 dans le cas où chaque paquet a été codé par un codeur de Reed Solomon et comprend, comme en figure 3, 16 multiplets de redondance. Si le nombre de mots erronés est inférieur à nmax, le décodeur 102 corrige les multiplets erronés. Dans le cas contraire, les multiplets erronés ne sont pas corrigés.

Par ailleurs, le décodeur 102 effectue un marquage des multiplets de chaque paquet en rajoutant à chaque multiplet d'un paquet, que le multiplet soit un multiplet de données ou un multiplet de redondance, un bit appelé bit de validité indiquant si le paquet ne comprend que des multiplets sans erreur (ou dont les erreurs ont été corrigées) ou s'il comprend des multiplets non corrigibles. Par exemple, dans le signal s1, tous les multiplets appartenant à un paquet qui ne comprend pas d'erreur comportent un bit de validité égal à "0" et tous les multiplets appartenant à un paquet incluant des erreurs se voient attribuer un bit de validité égal à "1".

Selon une variante de réalisation de la chaîne A, le décodeur 102 effectue en outre une opération d'élimination des multiplets de redondance. Dans ce cas, la chaîne A comprend un codeur optionnel 103, représenté en pointillés en figure 9. Le codeur 103 a pour fonction de recalculer et replacer des multiplets de redondance dans le signal. Le calcul des multiplets de redondance est effectué selon le même procédé que celui utilisé par le codeur externe du circuit d'émission. Les bits de validité ne sont pas pris en compte pour le calcul des multiplets de redondance et, après calcul, chaque multiplet de redondance d'un paquet se voit attribuer un bit de validité identique à ceux attribués aux multiplets de données du paquet considéré.

Le signal s1 issu du décodeur 102 (on suppose par la suite que le codeur 103 n'est pas présent) est fourni à un dispositif d'entrelacement 104 noté "Interleave". Le dispositif d'entrelacement 104 effectue un brassage des multiplets des paquets identique au brassage effectué par le dispositif d'entrelacement du circuit d'émission et fournit un signal s2". On notera que le signal s2" fourni par le dispositif 104 est une version corrigée du signal prédécodé s1", des erreurs ayant été éliminées par le décodeur 102 lors du traitement des éléments de redondance.

La figure 10 est un schéma illustrant la forme des signaux s1', s1 et s2" du circuit de la figure 9. Deux paquets P1 et P2 du signal s1' sont représentés. Les parties hachurées représentent des multiplets erronés. On suppose que le paquet P1 comprend 4 multiplets erronés, que le paquet P2 comprend 12 multiplets erronés et que le nombre maximal de multiplets corrigibles est nₘₐₓ = 8. Seuls les multiplets erronés du paquet P1 peuvent être corrigés par le décodeur 102, le paquet P2 comprenant un trop grand nombre de multiplets erronés. Comme cela est visible sur le signal s1, les multiplets du paquet P1 sont tous corrects et chaque multiplet de ce paquet inclut un bit de validité égal à 0. Les multiplets erronés du paquet P2 sont par contre inchangés et tous les multiplets du paquet P2 ont un bit de validité à 1. Chaque multiplet de redondance est également marqué avec un 1 ou un 0 selon respectivement qu'il appartient à un paquet présentant des multiplets marqués avec des 1 ou des 0. Après brassage par le dispositif d'entrelacement 104, les multiplets marqués avec un "1" se trouvent en général éparpillés au milieu des multiplets marqués avec un "0" pour former le signal s2".

Le circuit de la figure 9 comprend en outre un système ou chaîne de décodage B. La chaîne B comprend un dispositif de temporisation 110 noté "Del". Le dispositif 110 reçoit le signal codé x et fournit un signal x1 respectivement identique au signal x mais retardé par rapport à ce dernier. Le retard introduit par le dispositif 110 correspond au nombre de coups d'horloge nécessaire à la chaîne A pour fournir le signal s2". Le signal x1 est transmis à un décodeur 111, nommé aussi dispositif de décodage 111, qui reçoit par ailleurs le signal s2" fourni par le dispositif 104. Le dispositif de décodage 111 utilise des parties sans erreur du signal s2" pour améliorer le décodage du signal x1. Ainsi, le signal s3" fourni par le dispositif de décodage 111 est un signal présentant moins d'erreurs que le signal s1" fourni par le décodeur 100. Le signal s3" est fourni à un dispositif de désentrelacement 112 noté "Deinterleave" de même fonction que le dispositif 101. Le dispositif 112 fournit un signal s3' à un décodeur 113, de même fonction que le décodeur 12 de la figure 2. Le décodeur 113 fournit un signal s3 qui correspond au signal décodé fourni par le circuit de la figure 9. Du fait que le signal s3" fourni par le dispositif 111 présente moins d'erreurs que le signal s1' fourni par le décodeur 100, le décodeur 113 de la chaîne B peut corriger des erreurs qui n'ont pas pu être corrigées par le décodeur 102 de la chaîne A et le circuit de la présente invention permet de corriger davantage d'erreurs que les circuits de l'art antérieur.

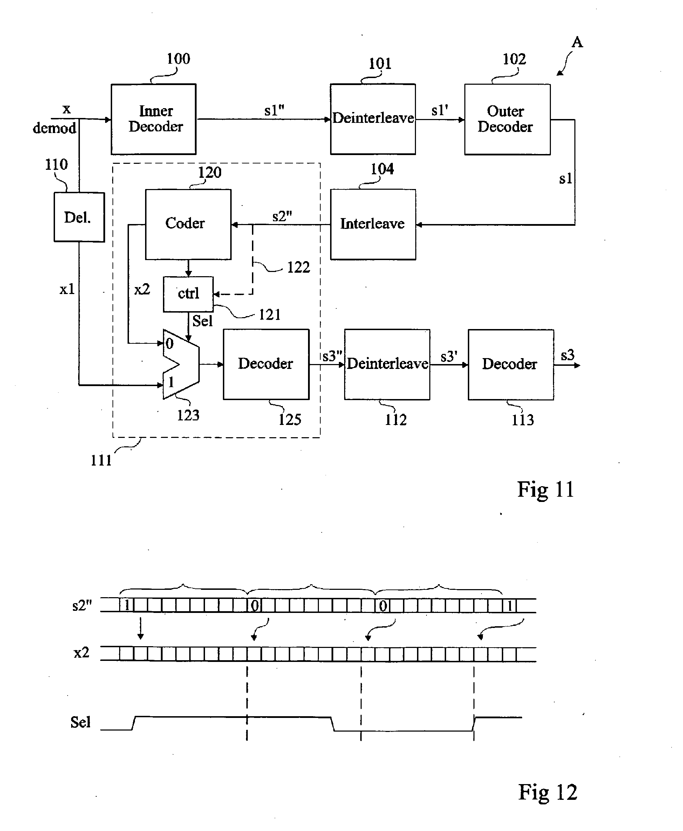

Deux modes de réalisation du dispositif de décodage 111 sont décrits ci-après, en relation avec les figures 11 à 15.

La figure 11 reprend la figure 9, le codeur optionnel 103 n'étant pas représenté, avec une représentation détaillée d'un premier mode de réalisation du dispositif de décodage 111.

En figure 11, le dispositif de décodage 111 comprend un codeur 120 qui reçoit le signal s2" fourni par le dispositif 104. Le codeur 120 fournit un signal x2 correspondant à une version corrigée du signal x. Pour ce faire, le codeur 120 élimine d'abord les bits de validité du signal s2". Le codeur 120 code le signal résultant de la même manière que le codeur interne utilisé à l'émission. Si besoin est, les bits du signal obtenu, qui sont des "hard" bits, de valeur 0 ou 1, sont convertis dans un format comparable à celui des bits du signal x. Cela aura lieu notamment lorsque les bits du signal x sont des "soft" bits. Dans ce cas, on convertira les bits du signal x2 en "soft" bits, en mettant par exemple leur signe à + ou - selon la convention choisie pour les 1 et les 0 et leur grandeur, qui représente la probabilité d'avoir cette valeur, au maximum admissible pour les "soft" bits du signal x.

Le dispositif de décodage 111 comprend aussi un dispositif de commande 121. Le dispositif de commande 121 récupère les bits de validité du signal s2", soit à partir du codeur 120 lorsque le codeur 120 les élimine, soit directement à partir du signal s2" comme cela est suggéré par la ligne pointillée 122. Le dispositif de commande 121 élabore, à partir des bits de validité, un signal de sélection Sel servant à commander un multiplexeur 123.

Le multiplexeur 123 reçoit le signal x1 sur une première entrée et le signal x2 sur une seconde entrée. De façon générale, le multiplexeur 123 est commandé pour laisser passer les valeurs correctes du signal x2 et pour laisser passer le signal x1 dans les autres cas, c'est-à-dire quand les valeurs du signal x2 sont incorrectes ou quand on ne sait pas si elles sont correctes ou incorrectes.

La figure 12 illustre, à l'aide des signaux s2", x2 et Sel, la manière d'opérer du multiplexeur 123, dans le cas où le codeur 120 est un codeur convolutif à six bascules. Bien que cela ne soit pas représenté, le signal x2 est dans ce cas formé d'une suite de deux valeurs, issues de combinaisons de bits du signal s2". Dans l'exemple représenté, le signal Sel passe à "1" dès que le premier bit d'un multiplet erroné est introduit dans le codeur 120 et reste à "1" tant que des multiplets erronés sont présents dans le codeur 120. Le signal Sel repasse à 0 quand le dernier bit du dernier multiplet erroné sort du codeur 120, ou autrement dit, jusqu'à l'introduction du 6ème bit du multiplet correct suivant.

Le dispositif de décodage 111 comprend en outre un module de décodage 125, nommé aussi décodeur 125, relié à la sortie du multiplexeur 123. Le décodeur 125 est de même constitution que le décodeur 100. Comme le décodeur 125 reçoit un certain nombre de bits connus avec certitude, il fournit nécessairement un signal présentant moins d'erreurs que le signal fourni par le décodeur 100 et le signal en sortie du circuit selon la présente invention présente moins d'erreurs que les signaux de l'art antérieur.

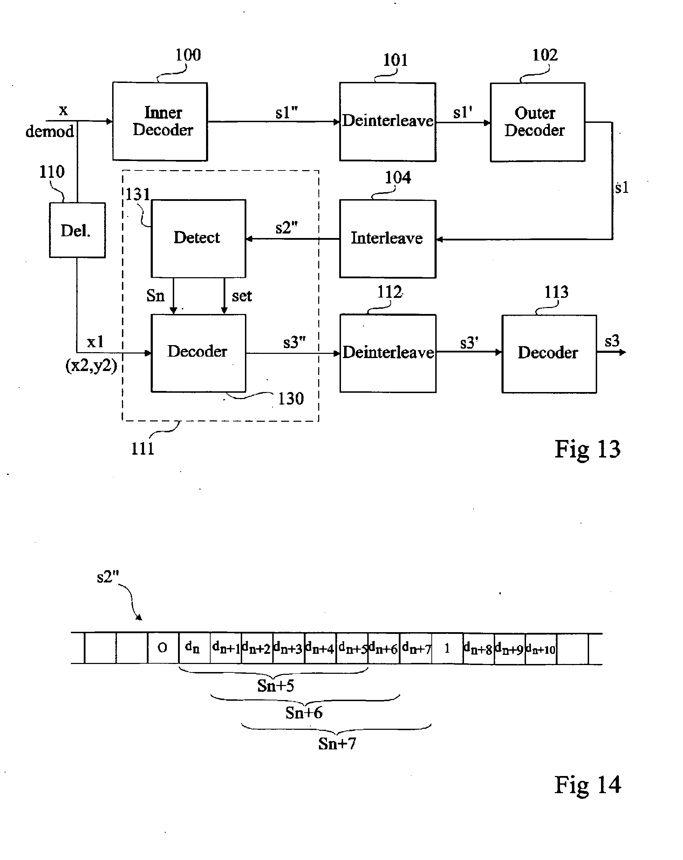

On va maintenant décrire un deuxième mode de réalisation du dispositif de décodage 111 en relation avec les figures 13 à 15.

La figure 13 reprend la figure 9 avec une représentation détaillée d'un second mode de réalisation du dispositif de décodage 111, particulièrement adapté au cas où le codeur interne à l'émission a été un codeur convolutif. Pour les besoins de la présentation, mais de façon non limitative, on suppose dans la description des figures 13 à 15 que le signal a été codé à l'aide d'un circuit comme celui de la figure 1, dans lequel le codeur externe est un codeur de type Reed Solomon et le codeur interne un codeur convolutif à 6 bascules, comme en figure 4. On suppose aussi qu'en figure 13, le décodeur 100 est un décodeur utilisant un algorithme de Viterbi. Le signal d'entrée x comprend des couples de deux valeurs traitées en parallèle, de même que le signal d'entrée retardé x1.

En figure 13, le dispositif de décodage 111 comprend un module de décodage 130, nommé aussi décodeur 130, qui reçoit le signal x1 sortant du dispositif de temporisation 110. Le dispositif de décodage 111 comprend en outre un dispositif de détection 131 noté "detect" qui reçoit le signal s2" fourni par le dispositif d'entrelacement 104. Le dispositif de détection 131 fournit au décodeur 130 un signal de positionnement "set" et un signal d'état Sₙ. Le décodeur 130 utilise un algorithme de Viterbi modifié selon la présente invention et fournit un signal s3" au dispositif de désentrelacement 112.

Le dispositif de détection 131 analyse le signal s2" afin d'en identifier les multiplets corrects. Pour chaque multiplet correct, le dispositif de détection intervient sur le fonctionnement du décodeur 130. En se référant à la modélisation du procédé mis en oeuvre par un décodeur de Viterbi décrite précédemment en relation avec la figure 7, le dispositif de détection 131 intervient afin d'accélérer et de rendre plus fiable le processus d'élimination de flèches du treillis.

La figure 14 est une représentation du signal s2" permettant d'illustrer le fonctionnement du dispositif de détection 131. Le signal s2" correspond, aux erreurs près, au signal S" fourni au codeur interne 3 du circuit d'émission associé, pour reprendre les références de la figure 1. Or, connaissant l'équivalent du signal S", il est possible de déterminer quel était l'état Sn des bascules du codeur interne du circuit d'émission, ici le codeur 15 de la figure 4, à un instant n correspondant à l'introduction dans la bascule 20 du n-ième bit du signal S". On appelle dₙ le bit du signal s2" correspondant au n-ième bit du signal S". Lors de l'opération effectuée par le décodeur 130 pour éliminer les flèches d'un treillis initialement complet, la connaissance d'un état Sn du codeur convolutif du circuit d'émission, permet d'identifier dans la colonne correspondant à l'état Sn le cercle par lequel passe le chemin final unique du treillis. Ainsi, pour chaque multiplet correct du signal s2", si dₙ correspond au premier bit du multiplet, on peut déduire de façon certaine, à partir des bits de ce multiplet, les états correspondants Sₙ₊₅, Sₙ₊₆ et Sₙ₊₇ du codeur convolutif associé. Les six premiers bits du multiplet donnent l'état S₍ₙ₊₅₎, la suite de bits du 2ème au 7ème bit donnent l'état S₍ₙ₊₆₎ et la suite de bits du 3ème au 8ème bit donnent l'état S₍ₙ₊₇). On peut par la suite identifier pour chaque colonne correspondant à un de ces états un cercle par lequel passe le chemin final. Ainsi, par exemple, si les six premiers bits du multiplet correct considéré sont 001010, le cercle "sélectionné" dans la colonne correspondant à l'état S₍ₙ₊₅₎ est le cercle associé à l'état possible 001010 des bascules du codeur de la figure 4.

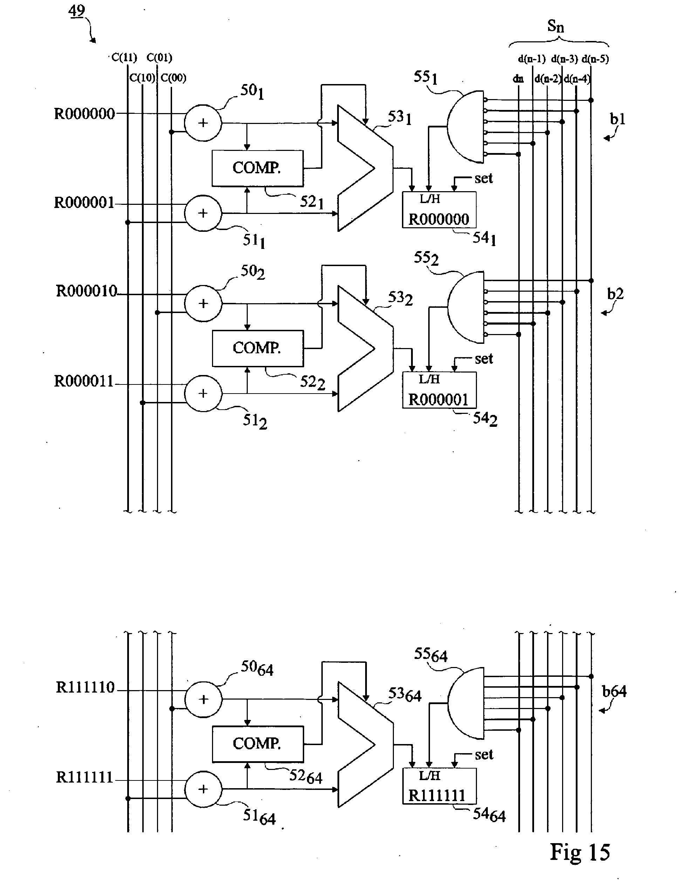

La figure 15 est un schéma d'un circuit 49 correspondant à une partie du décodeur 130 permettant de mettre en oeuvre le processus susmentionné. Le circuit 49 comprend 64 blocs b1 à b64 comprenant les mêmes éléments que les blocs du décodeur de la figure 8. Comme pour le décodeur de la figure 8, le j-ième bloc, j étant compris entre 1 et 64, comprend deux additionneurs 50ⱼ et 51ⱼ reliés à un comparateur 52ⱼ et à deux entrées d'un multiplexeur 53ⱼ. La sortie du multiplexeur 53ⱼ est connectée à un registre 54ⱼ. Le multiplexeur 53ⱼ est commandé par le comparateur 52ⱼ.

Le registre 54ⱼ est utilisé pour mémoriser la métrique associée au j-ième cercle de la n-ième colonne du treillis correspond à un état Sₙ. Le premier registre 54₁ est appelé R000000 car il est associé à l'état Sₙ possible "000000", et ainsi de suite jusqu'au registre 54₆₄ qui est appelé R111111 car associé à l'état Sₙ possible "111111".

Par ailleurs, un dispositif d'estimation, non représenté, calcule lors de l'arrivée de chaque nouveau couple du signal x1, quatre valeurs de coûts c(00), c(01), c(10) et c (11) pour chacun des 4 couples de valeurs possibles des signaux, comme cela a été décrit précédemment en relation avec les figures 6 à 8. Les valeurs des quatre coûts c(00), c(01), c(10) et c(11) sont fournies sur des lignes désignées également par c(00), c(01), c(10) et c(11) en figure 15.

Dans le cas du premier bloc b1, les entrées de l'additionneur 50₁ sont connectées au registre R000000 et à la ligne c(00). Les entrées de l'additionneur 51₁ sont connectées au registre R000001 et à la ligne c(11). De façon générale, les connexions aux additionneurs 50ⱼ et 51ⱼ du j-ième bloc peuvent se déduire d'un schéma du type de celui de la figure 6, mais réalisé pour un codeur convolutif à 6 bascules tel que celui de la figure 4.

Pour permettre au dispositif de détection 131 d'agir sur les registres 54₁ à 54₆₄ du décodeur, chaque bloc bⱼ comprend en outre une porte logique de type ET 55ⱼ comportant six entrées actives sur un niveau 0 ou 1. Un petit cercle est représenté devant une entrée quand elle est active sur un niveau 0. La sortie d'une telle porte ET est égale à 1 quand toutes ses entrées sont actives, et égale à 0 quand au moins une des entrées n'est pas active. Les six entrées de chaque porte ET sont connectées à six lignes de données dₙ, d ₍ₙ₋₁₎ , d₍ₙ₋₂₎, d₍ₙ₋₃₎, d₍ₙ₋₄₎, d₍ₙ₋₅₎ . La ligne de donnée dₙ indique la valeur, 0 ou 1, du n-ième bit d'information du signal s2". La ligne de donnée d₍ₙ₋₁₎ indique la valeur, 0 ou 1, du (n-1)-ième bit d'information du signal s2" et ainsi de suite. On notera que les données dₙ à d (n-5) correspondent à l'état Sₙ indiqué par le dispositif de détection 131. Par ailleurs, la porte ET du j-ième bloc est connectée à une entrée de commande L/H du registre 54ⱼ. De plus, chaque registre 54ⱼ est commandé par le signal de positionnement set fourni par le dispositif de détection 131.

Les portes ET 55₁ à 55₆₄ sont toutes différentes, de façon que pour un état Sₙ donné par le dispositif 131, une seule porte ET soit positionnée à 1, c'est-à-dire fournisse un 1. La porte ET 55₁ reliée au registre 54₁ "R000000" doit être positionnée à 1 quand l'état Sₙ présenté sur les lignes dₙ à d₍ₙ₋₅₎ est 000000. Pour ce faire, toutes les entrées de la porte ET 55₁ sont actives sur un niveau bas 0. De façon générale, la porte ET 55ⱼ reliée au registre 54ⱼ "Rx₁x₂x₃x₄x₅x₆", où x₁ à x₆ sont des valeurs de bits, doit être positionnée à 1 quand l'état Sₙ présenté sur les lignes dₙ à d₍ₙ₋₅₎ est égal à x₁x₂x₃x₄x₅x₆. Ainsi, la première entrée de la porte ET 55ⱼ reliée à la ligne dₙ est active à 0 ou 1 selon respectivement que x₁ est égal à 0 ou 1. De même, la deuxième entrée de la porte ET 55ⱼ reliée à la ligne d₍ₙ₋₁₎ est active à 0 ou 1 selon respectivement que x₂ est égal à 0 ou 1, et ainsi de suite pour chacune des entrées de la porte ET 55ⱼ.

Par l'intermédiaire du signal de positionnement set et du signal d'état Sₙ, le dispositif de détection 131 peut agir sur les registres 54₁ à 54₆₄ afin qu'ils mémorisent une valeur de métrique faible ou élevée. Un mode possible de fonctionnement du dispositif de détection 131 est le suivant. Le dispositif de détection 131 mémorise en continu les six derniers bits reçus du signal s2". Pour chaque nouveau bit du signal s2", le dispositif 131 actualise la valeur du signal d'état Sₙ fourni au décodeur 130 afin de mettre à jour les lignes de données dₙ à d₍ₙ₋₅₎. Le signal de positionnement set est par défaut inactif, par exemple au niveau "0", les registres 54₁ à 54₆₄ mémorisant alors les valeurs fournies par les multiplexeurs 53₁ à 53₆₄. Lorsque le dispositif 131 détecte un multiplet correct, ayant un bit de validité à "0", il attend d'avoir reçu le sixième bit du multiplet pour activer le signal de positionnement set. Le registre 54 mémorisant une valeur correspondant à la métrique associée à l'état Sₙ courant se voit alors attribuer une valeur faible, par exemple égale à 0. Les autres registres se voient attribuer une valeur élevée, par exemple égale à la valeur maximale pouvant être mémorisée par un registre 54. De façon générale, la valeur attribuée à un registre 54ⱼ est basse ou élevée selon que le niveau logique en sortie de la porte ET 55ⱼ associée est respectivement 1 ou 0. Lors de la réception des 7ème et 8ème bits du multiplet, le dispositif 131 maintient le signal set actif à 1. Le signal d'état Sₙ est réactualisé après réception de chacun de ces bits et chaque registre 54 est positionné à une valeur faible ou élevée selon que la valeur de métrique associée au registre considéré correspond ou non aux nouveaux états Sₙ. Une fois que l'état Sₙ obtenu après réception du dernier bit du multiplet a été pris en compte par les registres 54 du décodeur 130, le dispositif de détection 131 désactive le signal set. Les opérations décrites ci-dessus sont répétées pour chaque multiplet correct reçu par le dispositif de détection 131. Bien entendu, au cas où plusieurs multiplets corrects se suivent, il n'est pas nécessaire de prévoir que le signal set soit désactive entre deux multiplets corrects.

Si on se réfère à la modélisation sous forme de treillis du processus mis en oeuvre par le décodeur 130, dans le mode de fonctionnement du dispositif de détection 131 décrit précédemment, on détermine précisément les cercles par lesquels passe le chemin final pour un certain nombre de colonnes, par exemple un peu moins de 3 colonnes sur 8. Cette détermination précise permet de simplifier et de fiabiliser le processus d'élimination des flèches. Par conséquent, le signal fourni par le décodeur 130 comprend moins d'erreurs que le signal fourni par le décodeur 100 de la chaîne A du circuit.

Il en résulte, comme précédemment, que le décodeur 113 permettra de corriger davantage d'erreurs que le décodeur 102 et que le signal fourni par le circuit de la présente invention présentera moins d'erreurs que les signaux décodés selon l'art antérieur.

Des généralisations des circuits et procédés selon la présente invention sont à la portée de l'homme de l'art. Par exemple, un circuit de décodage selon la présente invention peut comprendre un nombre M de chaînes de décodage supérieur à deux, les ou des parties sans erreur du signal de la j-ème chaîne étant utilisées lors du décodage de la chaîne j+1.

Les exemples de circuits décrits ci-dessus le sont à titre non limitatif et peuvent être modifiés par l'homme de l'art sans sortir du cadre de la présente invention. Par exemple, le décodeur 130 peut utiliser d'autres moyens que ceux décrits (mise au minimum de la métrique associée à l'état certain, mise au maximum de la métrique associée aux autres états) pour tenir compte des états certains du signal s2".

Par ailleurs, les deux chaînes de décodage A et B de la présente invention peuvent être réalisées à partir de dispositifs existants normalement prévus à d'autres fins.

On pourra par exemple modifier un circuit classique de réception "double-canaux" tel qu'illustré en figure 16. Le circuit de la figure 16 comprend deux canaux permettant de traiter deux signaux codés différents, reçus chacun sur une entrée a1 ou a2. Avant de parvenir aux entrées a1 et a2, bien que cela ne soit pas représenté, chaque canal comprend en général une antenne et un dispositif de réception ou tuner. Chaque canal comprend en outre un démodulateur 151, respectivement 152 et un circuit de décodage 161, respectivement 162, par exemple identiques aux circuits de la figure 2. Deux signaux décodés sont fournis sur des sorties c1, c2. Ce type de circuits existe par exemple dans les appareils de télévision permettant de visionner une chaîne de télévision, tandis qu'une autre chaîne est enregistrée par un enregistreur.

La figure 17 illustre un premier exemple montrant comment le circuit classique de la figure 16 peut être converti en un circuit de réception "simple-canal" selon la présente invention. Le circuit de la figure 17 comprend un premier canal comprenant un démodulateur 201 couplé à un circuit de décodage 211, et un second canal comprenant un démodulateur 202 couplé à un circuit de décodage 212. Le circuit de réception comprend en outre un multiplexeur 220 disposé entre le démodulateur 202 et le décodeur 212, la sortie du démodulateur 202 étant reliée à une des deux entrées du multiplexeur 220. Un dispositif de temporisation 221 est placé entre la sortie du démodulateur 201 et la seconde entrée du multiplexeur 220. Un dispositif de contrôle 222 reçoit des signaux fournis par le décodeur 211 et peut commander le décodeur 212. Un signal de sélection Sel commande le multiplexeur 220, le dispositif de contrôle 222 et le circuit de décodage 212.

Le dispositif de contrôle 222 comprend des moyens de génération d'un signal correspondant à une version corrigée du signal fourni par le circuit de décodage 211. Le dispositif de contrôle 222 comprend en outre des moyens de commande du décodeur 212. Les circuits de décodage 211, 212 doivent par ailleurs être "adaptés", c'est-à-dire présenter une structure partiellement différente de celle des circuits de décodage 161, 162 du circuit de la figure 16, afin que le dispositif de contrôle 222 puisse commander ou accéder à des éléments de ces circuits.

Le circuit de la figure 17 peut fonctionner selon deux modes différents. Lorsque le circuit de la figure 17 fonctionne en circuit de réception double-canaux, le signal de sélection Sel est positionné, par exemple à 0, afin que le circuit de décodage 212 reçoive le signal codé fourni par le démodulateur 202. Le dispositif de contrôle 222 est alors inactif. Le circuit de décodage 212 traite alors de façon classique le signal reçu par le démodulateur 202 et les signaux de sortie c1 et c2 correspondent aux signaux d'entrée a1 et a2.

Lorsque le circuit de la figure 17 fonctionne en circuit de réception simple-canal selon la présente invention, le signal de sélection Sel est mis à "1" afin que le circuit de décodage 212 reçoive le signal a1 retardé fourni par le dispositif de temporisation 221. Le dispositif de contrôle 222 est alors activé. Le décodeur 212 traite alors tout ou partie du signal a1 retardé en fonction des commandes fournies par le dispositif de contrôle 222. Le dispositif de contrôle 222 sera par exemple réalisé à partir des exemples de circuits de décodage selon la présente invention décrits précédemment. Le circuit de décodage 211 et les moyens de génération du signal corrigé du dispositif de contrôle 222 constituent alors l'équivalent d'une chaîne de décodage A d'un circuit selon la présente invention. Le dispositif de temporisation 221 et les moyens de commande du dispositif de contrôle 222 constituent l'équivalent d'une chaîne de décodage B d'un circuit selon la présente invention.

Une utilisation possible du circuit de la figure 17 peut être la suivante. En cas de réception de deux canaux distincts, a1 et a2, par exemple en cas d'enregistrement d'une émission tandis qu'une autre émission est visionnée, le circuit de la figure 17 est utilisé en réception double-canaux. Lorsque seul un canal doit être reçu, le circuit de la figure 17 est utilisé en réception simple-canal selon la présente invention et présente un signal de meilleure qualité. Le signal Sel peut être actionné de manière manuelle ou automatique, par exemple, si l'on visionne une émission tandis qu'on en enregistre une autre, on peut prévoir de passer automatiquement en réception simple canal à la fin de l'enregistrement.

La figurer 18 illustre un second exemple montrant comment le circuit classique de la figure 16 peut être converti en un circuit de réception "simple-canal" selon la présente invention.

En figure 18, l'entrée a1 est couplée à un démodulateur 301 qui démodule le signal reçu par le premier canal. L'entrée a2 est couplée à un démodulateur 302 qui démodule le signal reçu par le deuxième canal. Les sorties des démodulateurs 301 et 302 sont couplées à un dispositif de recombinaison 310 qui fournit un signal b. Dans l'exemple de la figure 18, les deux canaux ne sont pas nécessairement accordés sur la même fréquence de réception mais fournissent chacun un signal correspondant à la même information émise. Le dispositif de recombinaison 310 choisit les meilleures parties des signaux fournis par les démodulateurs 301, 302 pour former le signal b. Par exemple, en réception mobile, deux antennes placées en deux endroits distincts d'un véhicule fournissent en général des signaux présentant des rapports signal sur bruit différents et le signal b sera formé du signal le meilleur. Aussi, en modulation COFDM, certaines fréquences de sous-porteuses seront mieux reçues par un canal et le signal b sera un mélange des signaux des deux canaux avec les sous-porteuses les moins bruitées.

Le signal b est ensuite fourni à un décodeur 320, et, via un élément à retard 321, à un décodeur 322. Le décodeur 320 correspond au décodeur 161 de l'art antérieur. Le décodeur 322, quant à lui, a été modifié pour pouvoir utiliser, selon la présente invention, tout ou partie des informations correctes du signal issu du décodeur 320. Le signal c, fourni par le décodeur 322, présente ainsi moins d'erreurs que le signal de l'art antérieur.

L'exemple de la figure 18 est particulièrement avantageux en ce sens que à la fois les deux démodulateurs et les deux décodeurs du circuit classique de la figure 16 sont utilisés pour améliorer la qualité du signal.

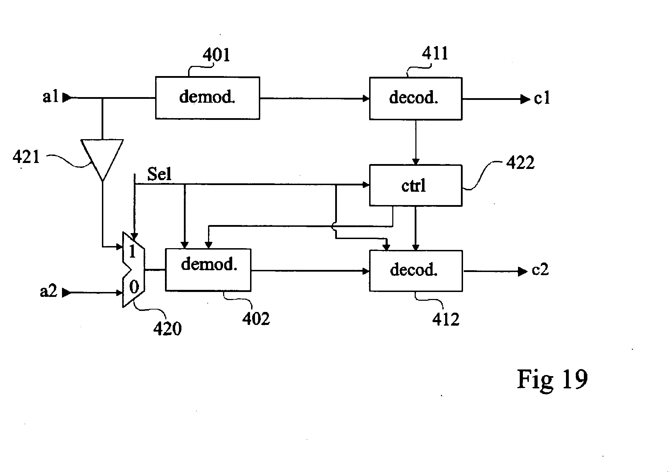

La figure 19 illustre un autre exemple montrant comment le circuit classique de la figure 16 peut être converti en un circuit de réception "simple-canal" selon la présente invention. Le circuit de la figure 19 comprend un premier canal comprenant un démodulateur 401 couplé à un circuit de décodage 411, et un second canal comprenant un démodulateur 402 couplé à un circuit de décodage 412. Le circuit de réception comprend en outre un multiplexeur 420 disposé en amont du démodulateur 402, la sortie du multiplexeur 420 étant reliée à l'entrée du démodulateur 402. Une première entrée du multiplexeur 420 reçoit le signal d'entrée a2 du second canal. Un dispositif de temporisation 421 est placé entre l'entrée du démodulateur 401 et la seconde entrée du multiplexeur 420. Un dispositif de contrôle 422 reçoit des signaux fournis par le décodeur 411 et peut commander le démodulateur 402 et le décodeur 412. Un signal de sélection Sel commande le multiplexeur 420, le dispositif de contrôle 422, le démodulateur 402 et le circuit de décodage 412.

Le dispositif de contrôle 422 comprend des moyens de génération d'un signal correspondant à une version corrigée du signal fourni par le circuit de décodage 411. Le dispositif de contrôle 422 comprend en outre des moyens de commande du démodulateur 402 et du décodeur 412. Le circuit de démodulation 402 et les circuits de décodage 411, 412 doivent par ailleurs être "adaptés", c'est-à-dire présenter une structure partiellement différente de celle du circuit de démodulation 152 et des circuits de décodage 161, 162 du circuit de la figure 16, afin que le dispositif de contrôle 422 puisse commander ou accéder à des éléments de ces circuits.

Le circuit de la figure 19 peut fonctionner selon deux modes différents. Lorsque le circuit de la figure 19 fonctionne en circuit de réception double-canaux, le signal de sélection Sel est positionné, par exemple à 0, afin que le circuit de démodulation 402 reçoive le signal d'entrée a2. Le dispositif de contrôle 422 est alors inactif. Les circuits de démodulation 402 et de décodage 412 fonctionnent alors de façon classique et les signaux de sortie c1 et c2 correspondent aux signaux d'entrée a1 et a2.

Lorsque le circuit de la figure 19 fonctionne en circuit de réception simple-canal selon la présente invention, le signal de sélection Sel est mis à "1" afin que le circuit de démodulation 402 reçoive le signal a1 retardé fourni par le dispositif de temporisation 421. Le dispositif de contrôle 422 est alors activé. Le démodulateur 402 et le décodeur 412 traitent alors tout ou partie du signal a1 retardé en fonction des commandes fournies par le dispositif de contrôle 422. Le dispositif de contrôle 422 sera par exemple réalisé à partir des exemples de circuits de décodage selon la présente invention décrits précédemment. Plus précisément, pour la commande du démodulateur 402, le dispositif de contrôle 422 comporte en outre un circuit de modulation correspondant. Le circuit de décodage 411 et les moyens de génération du signal corrigé du dispositif de contrôle 422 constituent alors l'équivalent d'une chaîne de décodage A d'un circuit selon la présente invention. Le dispositif de temporisation 421 et les moyens de commande du dispositif de contrôle 422 constituent l'équivalent d'une chaîne de démodulation et de décodage B d'un circuit selon la présente invention. Comme le démodulateur 402 reçoit des portions de signal modulé pour lesquelles les bits obtenus sont connus avec certitude, il fournit nécessairement un signal pour lequel la démodulation présente moins d'erreurs que le signal fourni par le démodulateur 401 et le signal en sortie du circuit selon la présente invention présente moins d'erreurs que les signaux de l'art antérieur.

Une utilisation possible du circuit de la figure 19 peut être la suivante. En cas de réception de deux canaux distincts, a1 et a2, par exemple en cas d'enregistrement d'une émission tandis qu'une autre émission est visionnée, le circuit de la figure 19 est utilisé en réception double-canaux. Lorsque seul un canal doit être reçu, le circuit de la figure 19 est utilisé en réception simple-canal selon la présente invention et présente un signal de meilleure qualité. Le signal Sel peut être actionné de manière manuelle ou automatique, par exemple, si l'on visionne une émission tandis qu'on en enregistre une autre, on peut prévoir de passer automatiquement en réception simple canal à la fin de l'enregistrement.

Bien entendu, la présente invention ne se limite pas aux circuits décrits ci-dessus et l'homme du métier apportera toute modification utile sans sortir du cadre de la présente invention. Par exemple, bien que cela n'ait pas été décrit, le circuit de la figure 18 peut être adapté pour permettre aussi la réception "doubles canaux" de la figure 16.

On notera par ailleurs que les applications de la présente invention sont nombreuses et variées. Un exemple typique d'utilisation est la téléphonie mobile, où le signal est en général fortement bruité.

## Revendications

1. Circuit de réception comprenant des premier et second canaux de réception permettant de recevoir des premier et second signaux modulés et codés distincts, le premier canal de réception comprenant un premier démodulateur (201) adapté à recevoir le premier signal modulé et codé et à fournir un signal codé à un premier système de décodage (211) et le second canal de réception comprenant un second démodulateur (202) couplé à un second système de décodage (212), le premier système de décodage étant propre à recevoir le signal codé et à fournir un premier signal décodé (c1) comportant des parties réputées correctes, **caractérisé en ce qu'**il comprend en outre :
un dispositif de temporisation (221) dont l'entrée est reliée à la sortie du premier démodulateur ;
un multiplexeur (220) à deux entrées et une sortie, les entrées du multiplexeur étant couplées respectivement à la sortie du dispositif de temporisation et à la sortie du second démodulateur, la sortie du multiplexeur étant couplée à l'entrée du second système de décodage ;
un dispositif de contrôle (222) comprenant des moyens de génération d'un signal corrigé à partir de signaux fournis par le premier système de décodage et des moyens de commande du second système de décodage ; et
un moyen de fourniture d'un signal de sélection (Sel) commandant le multiplexeur et le dispositif de contrôle, dans lequel, lorsque le signal de sélection est positionné pour laisser passer le signal fourni par le dispositif de temporisation, le second système de décodage est propre à fournir un second signal décodé (c2) à partir du signal codé et de parties réputées correctes du premier signal décodé.

2. Circuit de réception comprenant des premier et second canaux de réception permettant de recevoir des premier et second signaux modulés et codés distincts, le premier canal de réception comprenant un premier démodulateur (401) adapté à recevoir le premier signal modulé et codé et à fournir un signal codé à un premier système de décodage (411) et le second canal de réception comprenant un second démodulateur (402) couplé à un second système de décodage (412), le premier système de décodage étant propre à recevoir le signal codé et à fournir un premier signal décodé (c1) comportant des parties réputées correctes, **caractérisé en ce qu'**il comprend en outre :
un dispositif de temporisation (421) dont l'entrée est reliée à l'entrée du premier démodulateur ;
un multiplexeur (420) à deux entrées et une sortie, une entrée du multiplexeur étant couplée à la sortie du dispositif de temporisation, l'autre entrée du multiplexeur étant propre à recevoir le second signal modulé et codé, et la sortie du multiplexeur étant couplée à l'entrée du second démodulateur ;
un dispositif de contrôle (422) comprenant des moyens de génération d'un signal corrigé à partir de signaux fournis par le premier système de décodage et des moyens de commande du second système de décodage et du second démodulateur ; et
un moyen de fourniture d'un signal de sélection (Sel) commandant le multiplexeur et le dispositif de contrôle, dans lequel, lorsque le signal de sélection est positionné pour laisser passer le signal fourni par le dispositif de temporisation, le second système de décodage et le second démodulateur sont propres à fournir un second signal décodé (c2) à partir du premier signal modulé et codé et de parties réputées correctes du premier signal décodé.

3. Circuit de décodage selon la revendication 1 ou la revendication 2, dans lequel le premier système de décodage comprend un premier décodeur (100), un premier dispositif de désentrelacement (101) couplé au premier décodeur et un deuxième décodeur (102) couplé au premier dispositif de désentrelacement, et dans lequel le deuxième système de décodage comprend un troisième décodeur (111), un deuxième dispositif de désentrelacement (112) couplé au troisième décodeur et un quatrième décodeur (113) couplé au deuxième dispositif de désentrelacement.

4. Circuit de décodage selon la revendication 3, dans lequel le troisième décodeur (111) est couplé à un dispositif de temporisation (110) recevant le signal codé et au deuxième décodeur (102) par l'intermédiaire d'un dispositif d'entrelacement (104).

5. Circuit de décodage selon la revendication 4, dans lequel le signal (s2") fourni par le dispositif d'entrelacement (104) est formé de multiplets comportant des bits de validité indiquant si les multiplets sont corrects.

6. Circuit de décodage selon l'une quelconque des revendications 3 à 5, dans lequel le premier décodeur est un décodeur utilisant un algorithme de Viterbi, et dans lequel les deuxième et quatrième décodeurs sont des décodeurs correcteurs d'erreurs de type Reed Solomon.

7. Circuit de décodage selon l'une quelconque des revendications 3 à 6, dans lequel le troisième décodeur (111) comporte un ensemble de registres (54) mémorisant une métrique mise à jour périodiquement, et des moyens de contrôle (131 ; 55) propres à forcer le contenu des registres à une valeur déterminée en fonction des valeurs du signal fourni par le premier système de décodage.

8. Circuit de décodage selon la revendication 7, dans lequel les moyens de contrôle (131) détectent les multiplets corrects du premier signal et commandent le positionnement des registres (54) pour chaque suite de n bits consécutifs appartenant à des multiplets corrects.

9. Circuit de décodage selon l'une quelconque des revendications 4 à 6, dans lequel le troisième décodeur (111) comprend un codeur (120) couplé au dispositif d'entrelacement (104) et un multiplexeur (123) qui reçoit respectivement sur des première et seconde entrées le signal fourni par le dispositif de temporisation (110) et le signal fourni par le codeur (120) et fournit un signal à un cinquième décodeur (125), le multiplexeur étant commandé par un dispositif de commande (121) agissant en fonction de la validité du signal alimentant le codeur.

## Claims

1. A receive circuit comprising first and second receive channels enabling receiving first and second distinct modulated and coded signals, the first receive channel comprising a first demodulator (201) capable of receiving the first modulated and coded signal and of providing a coded signal to a first decoding system (211) and the second receive channel comprising a second demodulator (202) coupled to a second decoding system (212), the first decoding system being capable of receiving the coded signal and of providing a first decoded signal (c1) comprising portions considered correct, **characterized in that** it further comprises:
a delay device (221) having an input connected to the output of the first demodulator;
a multiplexer (220) with two inputs and one output, the inputs of the multiplexer being respectively coupled to the output of the delay device and to the output of the second demodulator, the output of the multiplexer being coupled to the input of the second decoding system;
a control device (222) comprising means for generating a corrected signal from signals provided by the first decoding system and means for controlling the second decoding system; and
means for providing a selection signal (Sel) controlling the multiplexer and the control device, wherein, when the selection signal is positioned to let through the signal provided by the delay device, the second decoding system is capable of providing a second decoded signal (c2) from the coded signal and from portions considered correct of the first decoded signal.

2. A receive circuit comprising first and second receive channels enabling receiving first and second distinct modulated and coded signals, the first receive channel comprising a first demodulator (401) capable of receiving the first modulated and coded signal and of providing a coded signal to a first decoding system (411) and the second receive channel comprising a second demodulator (402) coupled to a second decoding system (412), the first decoding system being capable of receiving the coded signal and of providing a first decoded signal (c1) comprising portions considered correct, **characterized in that** it further comprises:
a delay device (421) having an input connected to the input of the first demodulator;
a multiplexer (420) with two inputs and one output, one input of the multiplexer being coupled to the delay device, the other input of the multiplexer being capable of receiving the second modulated and coded signal, and the output of the multiplexer being coupled to the input of the second demodulator;
a control device (422) comprising means for generating a corrected signal from signals provided by the first decoding system and means for controlling the second decoding system and the second demodulator; and
means for providing a selection signal (Sel) controlling the multiplexer and the control device, wherein, when the selection signal is positioned to let through the signal provided by the delay device, the second decoding system and the second demodulator are capable of providing a second decoded signal (c2) from the first modulated and coded signal and from portions considered correct of the first decoded signal.

3. The decoding circuit of claim 1 or 2, wherein the first decoding system comprises a first decoder (100), a first deinterleave device (101) coupled to the first decoder, and a second decoder (102) coupled to the first deinterleave device, and wherein the second decoding system comprises a third decoder (111), a second deinterleave device (112) coupled to the third decoder, and a fourth decoder (113) coupled to the second deinterleave device.

4. The decoding circuit of claim 3, wherein the third decoder (111) is coupled to a delay device (110) receiving the coded signal and to the second decoder (102) via an interleave device (104).

5. The decoding circuit of claim 4, wherein the signal (s2") provided by the interleave device (104) is formed of bytes comprising validity bits indicating whether the bytes are correct.

6. The decoding circuit of any of claims 3 to 5, wherein the first decoder is a decoder using a Viterbi algorithm, and wherein the second and fourth decoders are error-correction decoders of Reed-Solomon type.

7. The decoding circuit of any of claims 3 to 6, wherein the third decoder (111) comprises a set of registers (54) storing a periodically-updated metric, and control means (131 ; 55) capable of forcing the content of the registers to a determined value according to the values of the signal provided by the first decoding system.

8. The decoding circuit of claim 7, wherein the control means (131) detect the correct bytes of the first signal and control the positioning of the registers (54) for each sequence of n consecutive bits belonging to correct bytes.

9. The decoding circuit of any of claims 4 to 6, wherein the third decoder (111) comprises an encoder (120) coupled to the interleave device (104) and a multiplexer (123) which respectively receives on first and second inputs the signal provided by the delay device (110) and the signal provided by the encoder (120) and provides a signal to a fifth decoder (125), the multiplexer being controlled by a control device (121) acting according to the validity of the signal supplying the encoder.

## Patentansprüche

1. Ein Empfangsschaltkreis, der erste und zweite Empfangskanäle aufweist, zum Ermöglichen des Empfangs von ersten und zweiten unterschiedlich modulierten und codierten Signalen, wobei der erste Empfangskanal einen ersten Demodulator (201) aufweist, der in der Lage ist zum Empfangen des ersten modulierten und codierten Signals und zum Vorsehen eines codierten Signals an ein erstes Decodierungssystem (211) und, wobei der zweite Empfangskanal einen zweiten Demodulator (202) aufweist, gekoppelt an ein zweites Decodierungssystem (212), wobei das erste Decodierungssystem in der Lage ist zum Empfangen des kodierten Signals und zum Vorsehen eines ersten dekodierten Signals (c1), das Teile aufweist, die als korrekt betrachtet werden, **dadurch gekennzeichnet, dass** es weiterhin Folgendes aufweist:
ein Verzögerungsgerät bzw. -einheit (221) mit einem Eingang verbunden mit dem Ausgang des ersten Demodulators;
einem Multiplexer (220) mit zwei Eingängen und einem Ausgang, wobei die Eingänge des Multiplexers entsprechend mit dem Ausgang des Verzögerungsgeräts bzw. -einheit und mit dem Ausgang des zweiten Demodulators gekoppelt sind, wobei der Ausgang des Multiplexers gekoppelt ist mit dem Eingang des zweiten Decodierungssystems;
eine Steuereinheit (222), die Mittel zum Generieren eines korrigierten Signals von Signalen, die von dem ersten Decodierungssystem vorgesehen sind, und Mittel zum Steuern des zweiten Decodierungssystems aufweist; und
Mittel zum Vorsehen eines Auswahlsignals (Sel), das den Multiplexer und die Steuereinheit steuert, wobei, wenn das Auswahlsignal so positioniert ist bzw. eingestellt ist, das Signal, das von der Verzögerungseinheit vorgesehen ist, durchzulassen, das zweite Decodierungssystem in der Lage ist zum Vorsehen eines zweiten decodierten Signals (c2) von dem codierten Signal und von Teilen, die von dem ersten decodierten Signal als korrekt betrachtet werden.

2. Ein Empfangsschaltkreis, der erste und zweite Empfangskanäle aufweist, zum Ermöglichen des Empfangs von ersten und zweiten unterschiedlich modulierten und codierten Signalen, wobei der erste Empfangskanal einen ersten Demodulator (401) aufweist, der in der Lage ist zum Empfangen des ersten modulierten und codierten Signals und zum Vorsehen eines codierten Signals an ein erstes Decodierungssystem (411) und, wobei der zweite Empfangskanal einen zweiten Demodulator (402) aufweist, gekoppelt an ein zweites Decodierungssystem (412), wobei das erste Decodierungssystem in der Lage ist zum Empfangen des codierten Signals und zum Vorsehen eines ersten decodierten Signals (c1), das Teile, die als korrekt betrachtet werden, aufweist, **dadurch gekennzeichnet, dass** es weiterhin Folgendes aufweist:
eine Verzögerungseinheit (421) mit einem Eingang, der mit dem Eingang des ersten Demodulators verbunden ist;
einem Multiplexer (420) mit zwei Eingängen und einem Ausgang, wobei ein Eingang des Multiplexers gekoppelt ist mit der Verzögerungseinheit, der andere Eingang des Multiplexers in der Lage ist zum Empfangen des zweiten modulierten und codierten Signals, und der Ausgang des Multiplexers gekoppelt ist an den Eingang des zweiten Demodulators;
eine Steuereinheit (422), die Mittel zum Generieren eines korrigierten Signals von Signalen, die von dem ersten Decodierungssystem vorgesehen sind, , und Mittel zum Steuern des zweiten Decodierungssystem und des zweiten Demodulators aufweist; und
Mittel zum Vorsehen eines Auswahlsignals (Sel) zum Steuern des Multiplexers und der Steuereinheit, wobei, wenn das Auswahlsignal positioniert ist bzw. eingestellt ist, das Signal, das von der Verzögerungseinheit vorgesehen ist, durchzulassen, das zweite Decodierungssystem und der zweite Demodulator in der Lage ist zum Vorsehen eines zweiten decodierten Signals (c2) von dem ersten modulierten und codierten Signal und von Teilen, die von dem ersten decodierten Signal als korrekt betrachtet werden.

3. Decodierungsschaltkreis nach Anspruch 1 oder 2, wobei das erste Decodierungssystem einen ersten Decodierer (100), eine erste Entverschachtelungseinheit (101) gekoppelt an den ersten Decoder, und einen zweiten Decodierer (102) gekoppelt an die erste Entverschachtelungseinheit, aufweist, und wobei das zweite Decodierungssystem einen dritten Decodierer (111), eine zweite Entverschachtelungseinheit (112) gekoppelt an den dritten Decoder, und einen vierten Decodierer (113) gekoppelt an die zweiten Entverschachtelungseinheit aufweist.

4. Decodierungsschaltkreis nach Anspruch 3, wobei der dritte Decodierer (111) an eine Verzögerungseinheit (110) zum Empfangen eines codierten Signals und an den zweiten Decodierer (102) über eine Verschachtelungseinheit (104) gekoppelt ist.

5. Decodierungsschaltkreis nach Anspruch 4, wobei das Signal (s2"), das von der Verschachtelungseinheit (104) vorgesehen ist, aus Bytes gebildet ist, die Gültigkeits-Bits aufweisen, und zwar zur Anzeige, ob die Bytes korrekt sind.

6. Decodierungsschaltkreis nach einem der Ansprüche 3 bis 5, wobei der erste Decodierer ein Decodierer ist, der einen Viterbi Algorithmus verwendet, und wobei der zweite und vierte Decodierer Fehlerkorrektur-Decodierer des Reed-Solomon-Typs sind.

7. Decodierungsschaltkreis nach einem der Ansprüche 3 bis 6, wobei der dritte Decodierer (111) einen Satz von Registern (54) aufweist, zum Speichern einer periodisch aktualisierten Metrik, und Steuermittel (131; 55), die in der Lage sind zum Forcieren des Inhalts der Register auf einen bestimmten Wert gemäß den Werten des Signals, das von dem ersten Decodierungssystem vorgesehen wird.

8. Decodierungsschaltkreis nach Anspruch 7, wobei die Steuermittel (131) die korrekten Bytes des ersten Signals detektieren und die Positionierung bzw. Einstellung der Register (54) für jede Sequenz von n nachfolgenden Bits, die zu den korrekten Bytes gehören, steuern.

9. Decodierungsschaltkreis nach einem der Ansprüche 4 bis 6, wobei der dritte Decodierer (111) einen Codierer (120) gekoppelt an die Verschachtelungseinheit (104) und einen Multiplexer (123) aufweist, der entsprechend auf den ersten und zweiten Eingängen das Signal empfängt, das von der Verzögerungseinheit (110) vorgesehen wird, und das Signal, das von dem Codierer (120) vorgesehen wird, und ein Signal an den fünften Decodierer (125) vorsieht, wobei der Multiplexer von einer Steuereinheit (121) gesteuert wird, die gemäß der Gültigkeit des Signals, das den Codierer versorgt, agiert.
